Europäisches Patentamt

European Patent Office

Office européen des brevets

(11) Publication number: **0 140 032**
**B1**

(12) **EUROPEAN PATENT SPECIFICATION**

(45) Date of publication of patent specification: **28.02.90**

(21) Application number: **84110436.7**

(22) Date of filing: **03.09.84**

(51) Int. Cl.⁵: **C 23 C 14/34**, C 23 C 14/14, C 03 C 17/40

(54) **Method for coating substrates with a film by cathode sputtering.**

(30) Priority: **09.09.83 US 530553**
**09.09.83 US 530570**

(43) Date of publication of application:
**08.05.85 Bulletin 85/19**

(45) Publication of the grant of the patent:
**28.02.90 Bulletin 90/09**

(84) Designated Contracting States:
**BE CH DE FR GB IT LI LU SE**

(56) References cited:
**DE-A-3 118 957**
**DE-B-2 334 152**
**DE-B-2 924 824**
**DE-B-2 924 833**
**US-A-4 342 632**

(73) Proprietor: **PPG INDUSTRIES, INC.**
**One PPG Place**
**Pittsburgh Pennsylvania 15272 (US)**

(72) Inventor: **Criss, Russell Caldwell**
**105 Cornwall Drive**
**Pittsburgh Pennsylvania 15238 (US)**
Inventor: **Gillery, Frank Howard**
**2790 Indian Spring Lane**
**Allison Park Pennsylvania 15101 (US)**

(74) Representative: **Sternagel, Hans-Günther, Dr.**
**et al**
**Patentanwälte Dr. Michael Hann Dr. H.-G.**
**Sternagel Sander Aue 30**
**D-5060 Bergisch Gladbach 2 (DE)**

Courier Press, Leamington Spa, England.

## Description

Background of the Invention

The present invention relates generally to the art of sputtering transparent metallic films for solar energy control, and more particularly to the art of controlling the color, adhesion and durability of sputtered films.

Transparent films of metals such as silver, copper, nickel and cobalt are readily produced by electroless deposition methods. US—A—3,457,138 to Miller discloses an electroless wet chemical) method for producing transparent copper films over a thin transparent silver film on glass. Similarly produced wet chemical silver/copper films on glass have achieved commercial success as architectural products for solar energy control. The coating effectively reflects solar heat energy while presenting an aesthetically appealling low reflectance pinkish colored surface to the observer.

However, advances in coating technology provide alternative processes for producing transparent metallic films for solar energy control, such as chemical vapor deposition, vacuum evaporation deposition, and cathode sputtering. Cathode sputtering is particularly desirable for producing metallic films in a method that is fast and efficient on a large scale. US—A—4,166,018 to Chapin discloses a particularly useful sputtering process and apparatus which employ a magnetic field to improve cathode sputtering conditions. A sputtering apparatus is described in which a magnetic field is formed adjacent a planar sputtering surface. The field comprises arching lines of flux over a closed loop erosion region of the cathode surface.

In attempting to reproduce the properties of a wet chemical two-layer silver/copper film on glass by cathode sputtering, it was discovered that, using known cathode sputtering techniques to produce two-layer silver/copper films at various thicknesses and thickness ratios, the desirable low reflectance pinkish colored appearance of the wet chemical two-layer silver/copper film is not obtained. Rather, typical sputtering conditions result in two-layer silver/copper films that range in appearance from highly reflective bright silver to highly reflective bright copper depending on the silver/copper ratio and the orientation of the sample.

US—A—4,462,884 to Gillery and Criss entitled "Low Reflectance, Low Emissivity Sputtered Films" discloses a method for producing transparent two-layer silver/copper films having a low reflectance pinkish colored appearance by cathode sputtering. The method disclosed therein requires the deposition of a first layer of silver in a discontinuous agglomerated state. The deposition of a continuous copper film over the discontinuous agglomerated silver film produces the desired low reflectance pinkish colored appearance characteristic of the wet chemical product. The deposition of silver in a discontinuous agglomerated state by cathode sputtering requires conditions which allow the silver arriving at the substrate surface sufficient time to agglomerate. This can be accomplished by either slowing the arrival rate of silver or increasing its mobility at the substrate surface. Slowing the arrival rate of the sputtered silver may be achieved by either lowering the power applied to the sputtering cathode or by increasing the gas pressure in the vacuum chamber in which the sputtering process is being performed. Increasing the mobility of the silver may be achieved by raising the temperature or decreasing the surface energy of the substrate.

Unfortunately, the discontinuous silver layer applied by cathode sputtering as described above does not have as good adhesion to glass as is desired for a commercial window unit. Moreover, the degree of agglomeration of the silver is difficult to control. The deposition of the silver layer is affected by the condition of the glass surface and the method used to clean it. The color and adhesion of a dual layer coating of silver and copper are particularly difficult to optimize if the glass substrate has been in storage and has stain or incipient stain on the surface to be costed.

DE—A—3,118,957 describes a method for coating a heat resistant adhesive gold layer on to oxidic substrates such as glass by means of an adhesive primer layer of ruthenium, ruthenium oxide or a mixture thereof which can be applied by cathode sputtering as well as by vacuum vapour deposition. This specific primer layer does not diffuse into the gold layer under heating up to 1000°C. Further primer films such as Fe, Ni and Cr or alloys thereof are mentioned in this document for use with gold films.

US—A—3,925,182 refers to a method for continuous production of sputter coated glass products by depositing a thin metal film on at least one of the surfaces of the glass sheet to reflect solar radiation. There is no mention of a specific metal for the film. A protective overcoat from siliceous material or aluminium oxide is also provided by cathode sputtering.

In DE—A—29 24 833 a heat reflecting glass sheet is described comprising a layer of gold having a thickness of between 7 and 10.5 nm which is deposited on a layer having interference characteristics and a neutralizing top coat. The interference layer is of zinc sulfide. An adhesive primer layer of a metal oxide may be provided between the glass substrate and the interference layer, e.g. a silica layer. The neutralizing layer is of chromium, iron, nickel, titanium or an alloy thereof or a chromium-aluminium-iron alloy. All the coatings are deposited by vacuum vapour deposition.

Furthermore, the stability and durability of a sputtering film of a metal such as silver or copper is not sufficient for long periods.

It is the technological problem of the invention to provide methods to overcome the disadvantages of the known products.

The problem of the invention is solved by a method for coating a glass substrate with a stable and durable metal film having a low adhesion to the substrate by cathode sputtering by firstly sputtering a primer layer and subsequently sputtering the low adhesion metal film on to the primer layer characterized by depositing a stainless steel primer layer on to the substrate by cathode sputtering which bonds oxidatively to the substrate surface and depositing the elemental metal film comprising a first layer of silver and a second layer of copper and depositing over the elemental film an overcoat of stainless steel which forms a dense oxide surface.

The present invention provides a method for achieving improved adhesion and color control of a sputtering film of a metal such as silver or copper by means of a primary layer of a metal stainless steel. The sputtering of a stainless steel primer layer is particularly useful in the production of silver/copper two-layer sputtered film on glsss. The stainless steel primer layer may be sputtered onto a substrate surface to a thickness on the order of an atomic layer to provide a suitable surface for the sputtering of more sensitive metals such as silver. Thicker primer layers are also useful, limited only by the desired final transmittance of coated article.

The present invention also provides a method for achieving improved stability and durability of a sputtering film of a metal such as silver or copper by means of an overcoat of stainless steel. The sputtering of a stainless steel protective overcoat is particularly useful in the production of silver/copper two-layer sputtered film on glass. The stainless steel overcoat may be sputtered onto the metal film to a thickness of least about $20 \times 10^{-10}$m. Thicker overcoats are also useful, limited only by the desired final transmittance of the coated article.

Description of the Preferred Embodiments

Nonmetallic transparent substrates such as glass, are coated with various metal and metal oxide films by cathode sputtering. The adhesion of some metallic films, notably silver, is not as good as is desired in a commercial product. In addition, the sputtered film may contain off-color spots, associated with the surface quality of the substrate, which render the product commercially unacceptable.

In accordance with the present invention, the film adhesion and substrate surface quality problems of the prior art are solved by means of a primer layer of an adherent, stable stainless steel composition which bonds oxidatively to the substrate surface. A stainless steel cathode is installed in a sputterig chamber. A clean transparent glass substrate is coated with a very thin primer layer of stainless steel prior to the deposition of silver and copper. An extremely thin layer of stainless steel, an essentially elemental layer only a few Angstroms thick, is sufficient to provide the desired adhesion and stability. Thicker primer layers are also useful, limited in thickness only by the desired transmittance of the final coated article.

In the embodiment of the invention, glass substrates to be coated with a two-layer silver/copper film by cathode sputtering are first coated with a stainless steel primer layer. The glass substrates are preferably first washed in a conventional washing operation to remove anv accumulated dirt and debris. The glass may be of any composition, but soda-lime-silica float glass is preferred. Typical float glass substrates have a transmittance of about 90 percent in the visible wavelength range. A clean glass substrate is placed in a sputtering chamber equipped with a stainless steel cathode. Sputtering is carried out to form a very thin primer layer of stainless steel on the glass surface. The thickness of the stainless steel primer layer may be as little as a few Angstroms, essentially an elemental layer, which decreases the transmittance by only about 1 to 2 percent. Such a stainless steel primer layer is sufficient to produce the desired adhesion and stability of subsequently sputtered films.

A two-layer film of silver and copper is to be sputtered, it is noted that a discontinuous silver film is not produced at useful thicknesses when silver is sputtered onto the stainless steel primer layer. As a result of the formation of a continuous silver layer, the resultant coated article may have a more highly reflective appearance and a more silvery or coppery color than is desired. In accordance with the present invention, a desired low reflectance pinkish colored silver/copper coating can be formed by increasing the thickness of the stainless steel primer layer, typically to about 20 to $25 \times 10^{-10}$m. If the thicker primer layer produces a lower reflectance than is desired, the reflectance can be raised by increasing the amount of silver relative to the amount of copper in the overlying two-layer film. The silver/copper two-layer films of the present invention may be stabilized by treatment with passivating agents.

The stability and durability problems of the prior art are solved by means of an overcoat of stainless steel which forms a dense oxide surface. Preferably, a stainless steel cathode is installed in a sputtering chamber. A clean, transparent substrate is preferably coated with a very thin primer layer of stainless steel prior to the deposition of silver and copper. The stainless steel overcoat is then sputtered over the silver and copper film to provide stability and durability to the exposed surface of the film. A thin layer of stainless steel, about $20 \times 10^{-10}$m thick, is sufficient to provide the desired stability and durability. Thicker overcoats are also useful, limited in thickness only by the desired transmittance of the final coated article.

The glass substrates to be coated with a two-layer silver/copper film by cathode sputtering are first coated with a stainless steel primer layer. A silver layer is then sputtered onto the primer layer, and a copper layer sputtered over the silver layer. Finally, a stainless steel overcoat is sputtered over the copper. The thickness of the stainless steel overcoat may be as little as about $20 \times 10^{-10}$m, which decreases the transmittance by only about 3 percent. Such a stainless steel overcoat is sufficient to produce the desired stability and durability of the underlying sputtered films. Thicker overcoats, on the order of 30 to 40 $\times$ 10$^{-10}$m, are generally preferred. Since the stainless steel overcoat further reduces the reflectance and transmittance of the coated article, the amount of silver may be further increased relative to the amount of copper to achieve the desired appearance.

### Example I

Clear float glass sheets measuring 3 by 2 feet (91 by 61 centimeters) and 6 millimeters thick are washed in a conventional washer. The transmission of the clear glass measured at 550 nanometers is about 90 percent. Clean glass sheets are coated using an in-line coating facility available from Airco-Temescal. The coater is a semi-continuous architectural coating facility capable of coating glass in sizes up to (7 by 12 feet) 2.1 by 3.7 meters on a conveyor while employing up to nine stationary cathodes which are (13 by 106 inches) 0.3 by 2.7 meters. Adjacent the planar sputtering surfaces is created a magnetic field comprising curved lines of magnetic flux which form a closed loop erosion region on the sputtering surface. This erosion region has a slightly irregular "oval racetrack" shape.

Stainless steel, silver and copper cathodes are installed in the coater in sequence. Each cathode is powered by a standard 120 kilowatt power supply operating under power control at various percentages of the rated power. The speed of the conveyor and number of cathodes may be varied to obtain the desired film thicknes. The atmosphere in the sputtering chamber is argon at a pressure of 0.1333 Pa (3 millitorr). In this example, the line speed is about (80 inches) about 2 meters per minute for a single pass under stainless steel, silver and copper cathodes in sequence. A transmission photometer which reads luminous transmission is installed on-line to monitor the transmission of the film after each stage of coating.

A glass substrate is conveyed under the stainless steel cathode, which comprises 19 percent chromium, 9 percent nickel, no more than 0.08 percent carbon and the balance iron, at an applied voltage of 360 volts. A stainless steel primer layer is sputtered onto the glass surface, decreasing the transmittance from about 90 percent to about 74 percent, corresponding to a stainless steel primer layer thickness of about 24 $\times$ 10$^{-10}$m. The stainless steel primer coated glass is then conveyed under the silver cathode. A continuous silver layer is sputtered, at an applied voltage of 331 volts, over the stainless steel primer layer, decreasing the transmittance of the coated glass to about 63 percent, corresponding to a silver layer thickness of about 22 $\times$ 10$^{-10}$m. Finally, the silver coated, stainless steel primed glass is conveyed under the copper cathode, at an applied voltage of 423 volts, sputtering a layer of copper over the silver layer, decreasing the transmittance to about 16 percent, corresponding to a copper layer thickness of about 257 $\times$ 10$^{-10}$.

Although a much thinner stainless steel layer, one that decreases the transmittance by only 1 to 2 percent, is effective to improve the adhesion of the silver layer, the stainless steel primer layer of this example, in combination with preferred silver and copper layer thicknesses, duplicates a desired low reflectance pinkish colored appearance. The final coated article has a luminous reflectance of about 34 percent and chromaticity coordinates of x = 0.3478 and y = 0.3333 with respect to Illuminant D—65. The improved adhesion of the silver/copper film with the stainless steel primer is evaluated by means of a tape test wherein an adhesive tape (Scotch® brand transparent tape) is pressed against the coating and then removed. Without the primer, essentially all of the silver/copper film is removed with the tape. However, when the silver/copper film is sputtered over a primer layer in accordance with the present invention, as in this example, none of the film is removed with the tape.

### Example II

A glass substrate is conveyed under a stainless steel cathode as in Example I. A stainless steel primer layer is sputtered onto the glass surface, decreasing tbe transmittance from about 90 percent to about 77 percent, corresponding to a stainless steel primer layer thickness of about 21 $\times$ 10$^{-10}$. The stainless steel primer coated glass is then conveyed under the silver cathode. A continuous silver layer is sputtered, at an applied voltage of 325 volts, over the stainless steel primer layer, decreasing the transmittance of the coated glass to about 63 percent, corresponding to a silver layer thickness of about 27 $\times$ 10$^{-10}$m. The silver coated, stainless steel primed glass is conveyed under the copper cathode, at an applied voltage of 424 volts, sputtering a layer of copper over the silver layer, decreasing the transmittance to about 16 percent, corresponding to a copper layer thickness of about 257 $\times$ 10$^{-}$·.304$^0$m. Finally, the stainless steel overcoat is sputtered at an applied voltage of 389 volts, decreasing the transmittance to 12 percent, corresponding to a stainless steel overcoat thickness of about 34 $\times$ 10$^{-10}$m.

Although thinner or thicker stainless steel layers are effective to improve the adhesion, stability and durability of the intermediate sputtered films, the stainless steel layers of this example, in combination with preferred silver and copper layer thicknesses, duplicate a desired low reflectance pinkish colored appearance. The final coated article has a luminous reflectance of about 37.5 percent and chromaticity coordinates of x = 0.3408 and y = 0.3363 with respect to Illuminant D—65. The improved stability of the silver/copper film with the stainless steel overcoat is evaluated by means of a heat soak test wherein coated samples are placed in an oven at (275°F.) 135°C. for 5 hours. Without the overcoat, untrested silver/copper films undergo significant visible color changes. Silver/copper films treated with a passivating agent do not significantly change color, but become nonuniform, e.g., streaked. However, when the silver/copper film is overcoated with stainless steel in accordance with the present invention, as in this example, there is no significant visible change in the film, in either the color or the uniformity.

## Claims

1. A method for coating a glass substrate with a stable and durable metal film having a low adhesion to the substrate by cathode sputtering by firstly sputtering a primer layer and subsequently sputtering the low adhesion metal film on to the primer layer characterized by, depositing a stainless steel primer layer on to the substrate by cathode sputtering which bonds oxidatively to the substrate surface and depositing the elemental metal film comprising a first layer of silver and a second layer of copper and depositing over the elemental film an overcoat of stainless steel which forms a dense oxide surface.

2. The method of claim 1 wherein the primer layer, elemental metal film layers and overcoat are deposited by magnetically enhanced cathode sputtering.

## Patentansprüche

1. Verfahren zum Beschichten eines Glassubstrates mit einem stabilen und dauerhaften Metallfilm, der eine niedrige Haftung auf dem Substrat aufweist, durch Kathodenzerstäubung, indem erst eine Grundierschicht zerstäubt wird und anschließend der Metallfilm mit geringer Haftung auf die Grundierschicht zerstäubt wird, gekennzeichnet durch Abscheiden einer Grundierschicht aus rostfreiem Stahl auf dem Substrat durch Kathodenzerstäubung, die sich oxidativ mit der Substratoberfläche verbindet, und Abscheiden des elementaren Metallfilmes, enthaltend eine erste Silberschicht und eine zweite Kupferschicht, und Abscheiden einer Deckschicht auf dem elementaren Metallfilm aus rostfreiem Stahl, die eine dichte Oxidoberfläche ausbildet.

2. Verfahren nach Anspruch 1, dadurch gekennzeichnet, daß die Grundierschicht, die elementaren Metallfilmschichten und die Deckschicht durch magnetisch verstärkte Kathodenzerstäubung abgeschieden werden.

## Revendications

1. Procédé pour revêtir un support de verre d'une pellicule de métal stable et durable, possédant une faible adhérence au support, par projection cathodique, en projetant d'abord une couche de fond et en projetant ensuite la pellicule de métal à faible adhérence sur la couche de fond, caractérisé en ce que l'on dépose une couche de fond en acier inoxydable sur le support, par projection cathodique, laquelle couche se lie par voie oxydante à la surface du support et on dépose la pellicule de métal élémentaire, comprenant une première couche d'argent et une seconde couche de cuivre et on dépose, par dessus la pellicile élémentaire, une couche supérieure d'acier inoxydable qui forme une surface d'oxyde dense.

2. Procédé suivant la revendication 1, caractérisé en ce que la couche de fond, les couches de pellicule métallique et la couche supérieure sont déposées par projection cathodique magnétiquement accentuée.